# EUROPÄISCHE PATENTANMELDUNG

(11) **EP 0 993 118 A2**
(43) Veröffentlichungstag der Anmeldung: **12.04.2000**
(21) Anmeldenummer: 99118231.2
(22) Anmeldetag: 14.09.1999
(51) Int. Cl.: H03K 17/0812

(54) **Schutzschaltung für einen Leistungs-Feldeffekttransistor**

(30) Priorität: 05.10.1998 DE 19845673
(71) Anmelder: GKR Gesellschaft für Fahrzeugklimaregelung mbH, D-71701 Schwieberdingen (DE)
(72) Erfinder: Doster, Michael, 70378 Stuttgart (DE); Motz, Juergen, 71691 Freiberg (DE); Singer, Horst, 71732 Tamm (DE); Falliano, Rolf, 73635 Steinenberg (DE)
(74) Vertreter: Behrens, Ralf Holger, Dipl.-Phys.

(57) **Zusammenfassung**

Die Erfindung betrifft eine Schutzschaltung für einen als Leistungsschalter geschalteten Feldeffekttransistor mit mindestens Drain-, Source- und Gate-Anschluß. Um eine Überlastung des FET bei verpolter Versorgungsspannung zu vermeiden, sieht die Erfindung vor, daß die Schaltspannung (U_{S}) dem Gate-Anschluß (G) über eine Ladungspumpe (IC₁) als Aussteuerspannung (U_{GS}) zuführbar ist, daß die Ladungspumpe (IC₁) über eine geeignete Schaltung (z.B. Graetz-Brückenschaltung, D₂ bis D₅) unabhängig von der Polung der angelegten Versorgungsspannung (U_{BATT}) versorgt ist und daß bei falscher Polung der Versorgungsspannung (U_{BATT}) über eine geeignete Schaltung (z.B. eine am Basisanschluß (GND) angeschaltete Diode (D₁)) die Ladungspumpe (IC₁) zur Abgabe einer Aussteuerspannung (U_{GS}) angesteuert wird.

## Beschreibung

### Stand der Technik

Die Erfindung betrifft eine Schutzschaltung für einen als Leistungsschalter verwendeten Feldeffekttransistor (FET), dessen Drain- Source- und Gate-Anschluß steuerbar ist.

Zur Veminderung der Verlustleistung werden bei Halbleiterschaltern Feldeffekttransistoren, z.B. MOS-FETs eingesetzt, die im leitenden Zustand einen sehr niederohmigen Widerstand zwischen Source- und Drain-Anschluß aufweisen. Dadurch ist es möglich, die Maßnahmen zur Kühlung der Halbleiterschalter auf ein Minimum zu reduzieren oder ganz entfallen zu lassen. So kann z.B. bei einem Widerstand von 5 mΩ und einem Laststrom I_{Load} von 10 A die Verlustleistung auf 0,5 W reduziert werden.

Im nichtleitenden bzw. leitenden Zustand des Halbleiterschalters bildet bei einem FET die zwischen Drain- und Source-Anschluß wirkende parasitäre Inversdiode einen Strompfad, wenn die Versorgungsspannung mit falscher Polung angelegt wird.

Bei einem durch den Lastwiderstand R_{Load} auf 10 A begrenzten Laststrom I_{Load} und einem Spannungsabfall von 0,8 V (Diodenabhängig) an der Inversdiode steigt die Verlustleistung auf 8 W an. Diese Verlustleistung kann ohne Kühlmaßnahmen (z.B. Kühlkörper) zur Zerstörung des FET führen.

Es ist Aufgabe der Erfindung, eine Schutzschaltung für einen Feldeffekttransistor (FET) der eingangs erwähnten Art zu schaffen, die auch bei falscher Polung der Versorgungsspannung einen Anstieg der Verlustleistung sicher verhindert.

Diese Aufgabe wird nach der Erfindung dadurch gekennzeichnet, daß die Schaltspannung dem Gate-Anschluß über eine Ladungspumpe als Aussteuerspannung zuführbar ist, daß die Ladungspumpe über eine Graetz-Brückenschaltung unabhängig von der Polung der angelegten Versorgungsspannung versorgt wird und daß bei falscher Polung der Versorgungsspannung über eine am Basisanschluß (GND) angeschaltete Diode die Ladungspumpe zur Abgabe einer Aussteuerspannung angesteuert wird.

Mit dieser Schutzschaltung wird bei falscher Polung der Versorgungsspannung der FET über den zusätzlichen Ansteuerstromkreis über die Diode und die Ladungspumpe ausgesteuert, so daß die Strecke zwischen dem Drain- und dem Source-Anschluß niederohmig wird. Die parasitäre Inversdiode wird praktisch kurzgeschlossen und somit die Verlustleistung auf den Wert bei ordnungsgemäßer Durchschaltung des FET reduziert. Auf einen Kühlkörper kann daher verzichtet werden oder die Maßnahmen für die Kühlung des FET können entsprechend reduziert werden. Eine Zerstörung des FET ist sicher verhindert.

Für die doppelte Ansteuerung der Ladungspumpe ist vorgesehen, daß die Ladungspumpe einen Steuereingang aufweist, dem die Schaltspannung zuführbar ist und der über die Diode mit dem Basisanschluß verbunden ist, wobei die Diode bei am Basisanschluß anliegender Versorgungsspannung (also bei Verpolung) leitend ist. Im Normalbetrieb gelangt die Schaltspannung auf den Steuereingang der Ladungspumpe, während bei falsch gepolter Versorgungsspannung der Steuereingang der Ladungspumpe über die Diode zwischen Basisanschluß und Steuereingang von der falsch an den Basisanschluß angelegten Versorgungsspannung angesteuert wird.

Die Schutzabschaltung ist universell einsetzbar, wenn beachtet wird, daß der FET als N-Kanal- oder P-Kanal-MOS-FET ausgebildet ist, wobei die Polaritäten der Versorgungsspannung, der Schaltspannung und der Aussteuerspannung entsprechend vertauscht sind und die Diode in zugeordneter Durchlaßrichtung zwischen Basisanschluß und Steuereingang der Ladungspumpe eingeschaltet ist.

Der Schaltungsaufwand kann dadurch klein gehalten werden, daß als Ladungspumpe eine handelsübliche integrierte Schaltung verwendet ist, dessen Eingangs- und Ausgangssignal an die Polarität der Schaltspannung angepaßt sind. Die Erfindung wird anhand eines als Stromlaufplan dargestellten Ausführungsbeispiel eines N-Kanal-MOS-FETs näher erläutert.

Bei einem N-Kanal-MOS-FET wird, wie die Vorzeichen + und - an den Klemmen U_{BATT} und GND der Endstufenschaltung angeben, die Versorgungsspannung U_{BATT} mit diesen Polaritäten richtig angelegt. Die Schaltspannung U_{S} schaltet den MOS-FET T₁ in den leitenden Schaltzustand, der mit seinem Drain-Anschluß D an der Versorgungaspannung U_{BATT} und mit seinem Source-Anschluß S über einen Lastwiderstand R_{Load} an dem Basispotential GND der Versorgungsspannung U_{BATT} angeschaltet ist. Der Gate-Anschluß G des MOS-FET T₁ wird über eine an sich bekannte Ladungspumpe IC₁ gesteuert, die entweder diskret aufgebaut oder als handelsübliche integrierte Schaltung zu beziehen ist.

Die Schaltspannung U_{S} wird dem Steuereingang IN der Ladungspumpe IC₁ zugeführt und im vorliegenden Ausführungsbeispiel mit gegenüber dem Basispotential GND positivem Potential angelegt, wie das Vorzeichen + der Schaltspannung U_{S} zeigt. Die Ladungspumpe IC₁ wird über die Klemmen VCC und VSS gespeist und zwar über eine Graetz-Brückenschaltung aus den Dioden D₂ bis D₅ unabhängig davon, ob die Versorgungsspannung U_{BATT} richtig oder falsch gepolt an die Endstufenschaltung angelegt wird. Im Regelfall erfolgt die Speisung der Ladungspumpe IC₁ über die Dioden D₂ und D₄, während bei verpolter Versorgungsspannung U_{BATT} die Ladungspumpe IC₁ über die Dioden D₃ und D₅ gespeist wird. Im Regelfall liefert die Ladungspumpe IC₁ bei der Ansteuerung des Steuereinganges mit der positiven Schaltspannung U_{S} eine positive Aussteuerspannung U_{GS} an den Gate-Anschluß G des MOS-FET T₁, der dabei in den leitenden Schaltzustand mit niederohmigem Widerstand zwischen Drain-Anschluß D und Source-Anschluß S übergeht. Es fließt der Lastatrom I_{Load} über den Lastwiderstand R_{Load} und am MOS-FET T₁ tritt eine kleine Verlustleistung auf, die keine besonderen Kühl-Maßnahmen für den MOS-FET T₁ erfordert.

Wird jedoch die Versorgungsspannung U_{BATT} verkehrt an die Endstufenschaltung angelegt, dann würde bedingt durch die parasitäre Inversdiode Dᵢ ein Laststrom in umgekehrter Richtung fließen, der zu einer wesentlich höheren Verlustleistung im MOS-FET T₁ führen würde und diesen zerstören könnte, wenn nicht Maßnahmen zur Kühlung des höher belasteten MOS-FET T₁ getroffen wären.

Um dies zu vermeiden, ist der Steuereingang IN über eine Diode D₁ mit dem Basisanschluß GND verbunden und zwar so, daß das verkehrt an diesem Anschluß angelegte positive Potential U_{BATT} die Ladungspumpe IC₁ ansteuert, die jetzt über die Dioden D₃ und D₅ gespeist ist und wieder eine Aussteuerspannung U_{GS} richtiger Polarität abgibt. In diesem Fall wird der MOS-FET T₁ sicher in den leitenden Schaltzustand gesteuert. Dieser Zustand kann nicht abgeschaltet werden, solange die Versorgungsspannung verpolt ist. Die niederohmige Verbindung zwischen dem Drain-Anschluß D und dem Source-Anschluß S schließt die parasitäre Invers-diode Dᵢ kurz, so daß im MOS-FET T₁ trotz falsch gepolter Versorgungsspannung U_{BATT} nur die kleine Verlustleistung auftritt.

Die an der parasitären Inversdiode Dᵢ abfallende Spannung U_{DS} wird auf die Spannung reduziert, die im leitenden Schaltzustand des MOS-FETs T₁ zwischen dem Drain-Anschluß D und dem Source-Anschluß S abfällt. Damit ist gewährleistet, daß der MOS-FET T₁ auch bei falsch angelegter Versorgungsspannung U_{BATT} nicht überlastet und zerstört wird. Es sind für diesen Störfall keine besonderen Maßnahmen für die Kühlung des MOS-FET T₁ erforderlich.

Selbstverständlich läßt sich die Schutzschaltung auch für einen P-Kanal-MOS-FET einsetzen, wenn man die Polaritäten der Versorgungsspannung U_{BATT}, der Schaltspannung U_{S} und der Aussteuerspannung U_{GS} vertauscht und eine Ladungspumpe IC₁ verwendet, die an die neue Polarität von Schaltspannung U_{S} und Aussteuerspannung U_{GS} angepaßt ist.

Das Ausführungsbeispiel zeigt einen MOS-FET T₁ in Drainschaltung, er kann jedoch auch in Sourceschaltung betrieben werden.

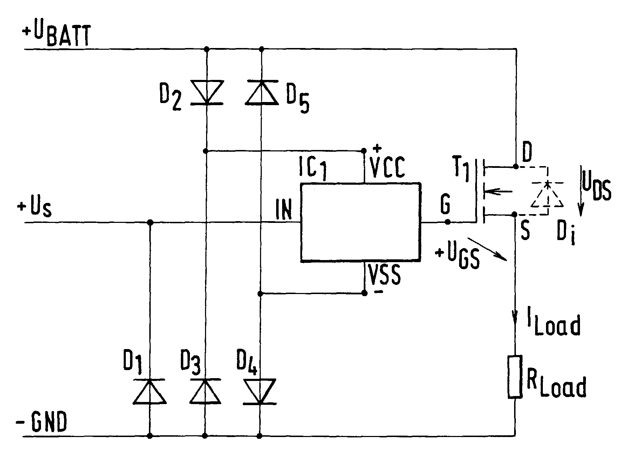

## Patentansprüche

1. Schutzschaltung für einen als Leistungsschalter geschalteten Feldeffekttransistor (FET) mit Drain-, Source- und Gate-Anschluß,
dadurch gekennzeichnet,
daß die Schaltspannung (U_{S}) dem Gate-Anschluß (G) über eine Ladungspumpe (IC₁) als Aussteuerspannung (U_{GS}) zuführbar ist,
daß die Ladungspumpe (IC₁) über eine geeignete Schaltung (z.B. Graetz-Brückenschaltung D₂ bis D₅) unabhängig von der Polung der angelegten Versorgungsspannung (U_{BATT}) versorgt wird und
daß bei falscher Polung der Versorgungsspannung (U_{BATT}) über eine geeignete Schaltung (z.B. eine am Basisanschluß (GND) angeschaltete Diode (D₁)) die Ladungspumpe (IC₁) zur Abgabe einer Aussteuerspannung (U_{GS}) angesteuert wird.

2. Schutzachaltung nach Anspruch 1,
dadurch gekennzeichnet,
daß die Ladungspumpe (IC₁) einen Steuereingang (IN) aufweist, dem die Schaltspannung (U_{S}) zuführbar ist und der über die Diode (D₁) mit dem Basisanschluß (GND) verbunden ist, wobei die Diode (D₁) bei am Basisanschluß (GND) anliegender Versorgungsspannung (U_{BATT}) leitend ist.

3. Schutzschaltung nach Anspruch 1 oder 2,
dadurch gekennzeichnet,
daß der FET als N-Kanal- oder P-Kanal-MOS-FET (T₁) ausgebildet ist, wobei die Polaritäten der Versorgungsspannung (U_{BATT}), der Schaltspannung (U_{S}) und der Aussteuerspannung (U_{GS}) entsprechend verbunden sind und die Diode (D₁) in zugeordneter Durchlaßrichtung zwischen Basisanschluß (GND) und Steuereingang (IN) der Ladungspumpe (IC₁) eingeschaltet ist.

4. Schutzschaltung nach einem der Ansprüche 1 bis 3,
dadurch gekennzeichnet,
daß als Ladungspumpe (IC₁) entweder eine diskret aufgebaute Lösung oder eine handelsübliche integrierte Schaltung verwendet wird, deren Eingangs- und Ausgangssignal an die Polarität der Schaltspannung (Uₛ) und der Aussteuerspannung (U_{GS}) angepaßt sind.

5. Schutzschaltung nach einem der Ansprüche 1 bis 4,
dadurch gekennzeichnet,
daß der MOS-FET (T₁) in Drain- oder Source-Schaltung betrieben ist.

6. Schutzschaltung nach einem der Ansprüche 1 bis 5,
dadurch gekennzeichnet,
daß der MOS-FET (T₁) mit der Ladungspumpe (IC₁) und den Dioden (D₁ ... D₅) als integrierte Schaltung ausgeführt sind (z.B. als ASIC).
